(19) Europäisches Patentamt
European Patent Office
Office européen des brevets

(11) **EP 3 679 382 B1**

(12) **FASCICULE DE BREVET EUROPEEN**

(45) Date de publication et mention de la délivrance du brevet:
**05.07.2023 Bulletin 2023/27**

(21) Numéro de dépôt: **18769632.3**

(22) Date de dépôt: **07.09.2018**

(51) Classification Internationale des Brevets (IPC):
*G01R 31/50* (2020.01)    *G01R 31/52* (2020.01)
*G01R 31/54* (2020.01)    *G01R 31/60* (2020.01)
*G01R 31/12* (2020.01)

(52) Classification Coopérative des Brevets (CPC):
**G01R 31/1272; G01R 31/50; G01R 31/52; G01R 31/54; G01R 31/60**

(86) Numéro de dépôt international:
**PCT/EP2018/074184**

(87) Numéro de publication internationale:
**WO 2019/048627 (14.03.2019 Gazette 2019/11)**

(54) **DISPOSITIF DE CONTRÔLE D'ISOLEMENT ET DE CONTINUITÉ D'AU MOINS UN CÂBLE ÉLECTRIQUE ET PROCÉDÉ DE CONTRÔLE ASSOCIÉ**

VORRICHTUNG ZUR ÜBERWACHUNG DER ISOLATION UND KONTINUITÄT VON ZUMINDEST EINEM ELEKTRISCHEN KABEL UND ENTSPRECHENDES ÜBERWACHUNGSVERFAHREN

DEVICE FOR MONITORING THE INSULATION AND CONTINUITY OF AT LEAST ONE ELECTRIC CABLE AND ASSOCIATED MONITORING METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.09.2017 FR 1700904**

(43) Date de publication de la demande:
**15.07.2020 Bulletin 2020/29**

(73) Titulaire: **Naval Group**
**75015 Paris (FR)**

(72) Inventeurs:
• **PAROIS-QUELENNEC, Eric**
  **44620 La Montagne (FR)**
• **CHERUEL, Richard**
  **44620 La Montagne (FR)**

(74) Mandataire: **Lavoix**
**2, place d'Estienne d'Orves**
**75441 Paris Cedex 09 (FR)**

(56) Documents cités:
JP-A- S57 161 560     US-A- 3 600 673
US-A- 3 986 106     US-A- 4 445 086
US-A- 5 155 440

**Description**

La présente invention concerne un dispositif et un procédé de contrôle d'isolement et/ou de la continuité d'au moins un câble électrique comprenant une pluralité de fils électriques.

L'invention concerne, par exemple, le domaine des bâtiments navals.

L'isolement et/ou la continuité électrique des câbles à bord des bâtiments navals doivent être régulièrement contrôlés.

Les bâtiments navals comprennent un nombre très important de câbles à tester.

Il existe des dispositifs de contrôle d'isolement et/ou de continuité de câbles électriques qui nécessitent de nombreuses manipulations des opérateurs pour effectuer les mesures.

En particulier, l'opérateur doit connecter un à un manuellement les fils électriques du câble au dispositif de contrôle et entrer manuellement les paramètres de réglage des mesures.

Il en résulte un temps relativement important pour réaliser un contrôle de l'isolement et/ou de la continuité des fils électriques du câble ainsi que de possibles erreurs de mesure.

Il est connu des documents US 3 986 106 A, US 4 445 086 A et US 5 155 440 A des dispositifs de contrôle d'isolement et/ou de continuité de câbles électriques.

En outre, les contrôles de la continuité et/ou de l'isolement des câbles sont réalisés dans des environnements exigus. Ceci est donc relativement fastidieux pour l'opérateur.

Un but de la présente invention est de proposer un dispositif de contrôle d'isolement et/ou de continuité d'au moins un câble électrique permettant de simplifier la réalisation des mesures d'isolement et/ou de continuité.

A cet effet, la présente invention a pour objet un dispositif de contrôle d'isolement et de continuité d'au moins un câble électrique comportant une pluralité de fils électriques, selon la revendication 1..

Le dispositif selon l'invention peut comprendre l'une ou plusieurs des caractéristiques des revendications 2 à 9 et la caractéristique selon laquelle le générateur de tension est isolé galvaniquement de l'ensemble électrique (i.e. l'installation électrique) comprenant les câbles à contrôler, ce qui revient à isoler galvaniquement le générateur de tension de l'installation électrique du bâtiment naval, prise(s) isolément ou suivant toutes les combinaisons techniquement réalisables.

L'invention a également pour objet un procédé de contrôle d'isolement et de continuité d'au moins un câble électrique comportant une pluralité de fils électriques, tel que défini dans la revendication 10.

L'invention sera mieux comprise à la lecture de la description qui va suivre, donnée uniquement à titre d'exemple, et se référant aux dessins annexés, sur lesquels :

-   la figure 1 est un schéma synoptique d'un dispositif de contrôle d'isolement et/ou de continuité selon l'invention,
-   la figure 2 est une vue schématique d'un circuit de mesure du dispositif de contrôle selon l'invention,
-   la figure 3 est une vue d'une interface d'interaction homme-machine propre à être affichée sur une interface utilisateur du dispositif de la figure 1,
-   la figure 4 est une vue d'une autre interface d'interaction homme-machine propre à être affichée sur une interface utilisateur du dispositif de la figure 1,
-   la figure 5 est une vue schématique de la face avant d'un premier boîtier du dispositif de contrôle de la figure 1,
-   la figure 6 est une vue schématique de la face arrière du premier boîtier de la figure 5, et
-   la figure 7 est une vue de face d'un deuxième boîtier du dispositif de contrôle de la figure 1.

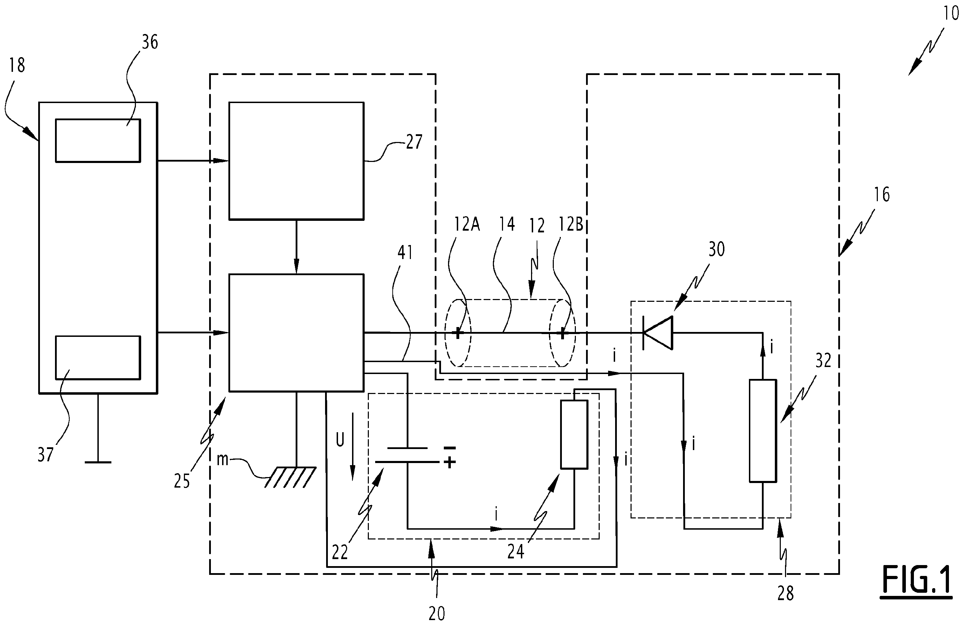

La figure 1 est un schéma synoptique d'un dispositif 10 de contrôle de l'isolement et/ou de la continuité électrique d'un câble électrique 12, propre à contrôler l'isolement et la continuité électrique du câble électrique 12.

De manière connue en soi, le câble électrique 12 comprend une pluralité $k$ de fils électriques 14. Le câble électrique 12 comprend, par exemple, jusqu'à soixante-trois fils électriques et dans ce cas, $k=63$. Sur la figure 1, afin de simplifier la présente description, un seul fil électrique 14 du câble 12 est représenté.

Un contrôle d'isolement du câble électrique 12 consiste à vérifier l'isolation électrique des fils électriques 14 conducteurs du câble 12 les uns par rapport aux autres ainsi que l'isolation électrique entre chaque fil électrique et la masse m.

Un contrôle de continuité du câble électrique 12 consiste à vérifier la continuité électrique d'au moins un fil 14 du câble 12, c'est-à-dire à vérifier que le courant Í circule sur toute la longueur du fil 14 entre ses deux extrémités.

Le dispositif de contrôle 10 comprend un circuit de mesure 16 connectable entre les deux bornes de chaque fil électrique 14 du câble 12 et une interface utilisateur 18 permettant de restituer des informations de mesure à l'utilisateur connectée au circuit de mesure 16.

Le circuit de mesure 16 comprend un étage de mesure 20 comprenant au moins un générateur de tension 22 et une résistance de mesure 24 en série du générateur de tension 22.

Dans cet exemple, le générateur de tension 22 de l'étage de mesure 20 est un générateur à tension variable, présentant une tension U jusqu'à 500 Volts (V) par exemple. Par exemple, différentes tensions U de 50 V, 250 V, 500 V sont propres à être générées par ce même générateur à tension variable. La résistance de mesure 24 présente une valeur $Rmes$ de 20,2 MΩ. Par exemple, la résistance de mesure 24 est composée d'une première résistance de 200 K$\Omega$ et d'une deuxième résistance de 20 M$\Omega$, montées en pont diviseur, de telle façon que la tension aux bornes de la plus faible des deux résistances, c'est-à-dire de la deuxième résistance, soit proportionnelle au courant de défaut i circulant entre deux fils lors d'une mesure d'isolement.

La tension aux bornes de la plus faible des deux résistances composant la résistance de mesure 24 est toujours inférieure à 5 V, gamme maximale de mesure des étages d'acquisition, quelle que soit la tension d'essai, c'est-à-dire la tension générée par le générateur à tension variable et la résistance de défaut en série, c'est-à-dire première résistance.

Le circuit de mesure 16 comprend, en outre, un étage de commutation 25, connecté à l'étage de mesure 20 et à une première extrémité 12A du câble électrique 12. L'étage de commutation 25 est propre à connecter automatiquement et successivement chaque fil électrique 14 du câble 12 au circuit de mesure 16 et/ou le circuit de mesure 16 à la masse m.

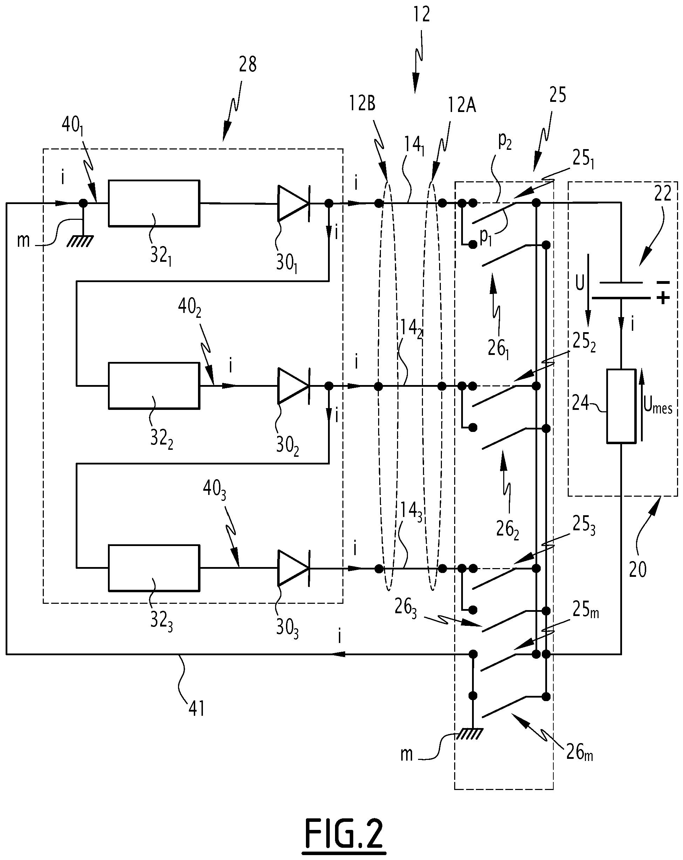

L'étage de commutation 25 comprend des commutateurs $25_1$, $25_2$, $25_3$, $25_m$, $26_1$, $26_2$, $26_3$, $26_m$ (visibles sur la figure 2), tels que des commutateurs électroniques, par exemple des commutateurs CMOS (de l'anglais « Complementary metal oxyde semi-conductor »).

Les commutateurs $25_1$, $25_2$, $25_3$, $25_m$, $26_1$, $26_2$, $26_3$, $26_m$ sont par exemple intégrés sur des cartes de commutations, par exemple quatre cartes de commutation comportant chacune un registre à décalage propre à piloter les commutateurs de la carte. Un registre à décalage comprend, de manière connue en soi, un ensemble de bascules synchrones propre à transmettre un signal de pilotage aux commutateurs $25_1$, $25_2$, $25_3$, $25_m$, $26_1$, $26_2$, $26_3$, $26_m$.

Comme visible sur la figure 1, l'étage de commutation 25 est connecté à une première extrémité 12A du câble 12, et en particulier à une première borne du fil 14.

Le circuit de mesure 16 comprend en outre un séquenceur 27 connecté à l'étage de commutation 25, propre à contrôler l'étage de commutation 25.

Le séquenceur 27 comprend un microcontrôleur non représenté et connu en soi, tel qu'un microcontrôleur programmable. Le microcontrôleur comprend notamment une unité centrale (CPU), une mémoire de programme et une mémoire de données adaptée pour traiter des résultats de calculs, et des ports d'entrée et de sortie propres à connecter le microcontrôleur aux autres éléments du dispositif de contrôle 10, en particulier à l'étage de mesure 20.

Un microcontrôleur programmable est un circuit logique séquentiel fonctionnant au rythme d'un signal d'horloge.

Ainsi, à chaque impulsion de l'horloge le nombre représenté par les bascules synchrones des registres à décalage des cartes de commutations est mis à jour et un signal de pilotage est destiné à être transmis aux commutateurs pour la connexion et la déconnexion d'un fil électrique 14 ou de la masse *m* du circuit de mesure 16.

Le circuit de mesure 16 comprend également un étage de bouclage 28 propre à être connecté à une deuxième extrémité 12B du câble 12.

L'étage de bouclage 28 est configuré pour fonctionner automatiquement selon au moins un des modes parmi deux modes de fonctionnement, isolant ou résistif, associés respectivement au contrôle d'isolement ou au contrôle de continuité du câble électrique 12.

L'étage de bouclage 28 comprend pour chaque fil électrique 14 au moins un composant à passage unidirectionnel du courant électrique tel qu'une diode 30, par exemple une diode redresseuse, et une résistance 32.

Ainsi, comme visible sur la figure 1, la deuxième borne du fil 14 est connectée à une diode 30 et à une résistance 32 montée, dans cet exemple, en série de la diode 30.

L'interface utilisateur 18 est connectée au séquenceur 27 et à l'étage de commutation 25 du circuit de mesure 16.

L'interface utilisateur 18 comprend un écran 36, tel qu'un écran tactile et, le cas échéant, un clavier 37 à partir duquel un utilisateur est propre à saisir la valeur d'une donnée d'entrée du dispositif de contrôle 10. Le clavier 37 est, par exemple, un clavier tactile destiné à être affiché sur l'écran 36 tactile.

En relation avec la figure 2, le circuit de mesure 16 du dispositif de contrôle 10 est ci-après détaillé.

Pour simplifier la présente description, le circuit de mesure 16 est connecté à un câble électrique 12 à contrôler comprenant trois fils électriques $14_1$, $14_2$, $14_3$.

On reconnaît sur cette figure, l'étage de mesure 20 connecté à l'étage de commutation 25. On reconnaît, en outre, sur cette figure, l'étage de bouclage 28, également appelé « bouchon », connecté à la deuxième borne de chaque fil $14_1$, $14_2$, $14_3$,

L'armure métallique du câble 12, reliée électriquement aux masses des connecteurs du câble 12 est propre à connecter l'étage de mesure 20 à l'étage de bouclage 28. Par souci de compréhension, l'amure du câble 12 est représentée sur la figure 2 par un fil 41. Le fil 41 est relié à la masse m.

Les commutateurs $25_1$, $25_2$, $25_3$, $25_m$, $26_1$, $26_2$, $26_3$, $26_m$ de l'étage de commutation 25 forment des couples de commutateurs, à savoir ($25_1$ -$26_1$), ($25_2$-$26_2$), (25s-26s}, ($25_m$-$26_m$). L'une des bornes de chaque couple de commutateurs est propre à être connectée respectivement à la première borne de chaque fil électrique $14_1$, $14_2$, $14_3$ ou au fil 41. L'autre borne de chaque couple de commutateurs est propre à être connectée à l'étage de mesure 20.

Autrement dit, l'une des bornes de chaque commutateur $25_1$, $25_2$ $25_3$, $26_1$, $26_2$, $26_3$ est connectée à l'étage de mesure 20 et l'autre borne de chaque commutateur $25_1$, $25_2$ $25_3$, $26_1$, $26_2$, $26_3$ est propre à être respectivement connectée en série à la première borne de

chaque fil électrique $14_1$, $14_2$, $14_3$.

Chaque commutateur $25_1$, $25_2$, $25_3$, $25_m$, $26_1$, $26_2$, $26_3$ est propre à être automatiquement piloté entre deux positions $p_1$, $p_2$. Dans la position ouverte $p_1$, le courant Í n'est pas propre à traverser le fil électrique $14_1$, $14_2$, $14_3$ auquel chaque couple de commutateurs $25_1$ -$26_1$, $25_2$ -$26_2$, $25_3$ -$26_3$ est propre à être connecté, les commutateurs $25_1$, $25_2$, $25_3$, $26_1$, $26_2$, $26_3$ ne connectant alors pas le fil $14_1$, $14_2$, $14_3$ au circuit de mesure 16. Dans la position fermée $p_2$, le courant électrique Í est propre à circuler à travers le fil électrique $14_1$, $14_2$, $14_3$ auquel l'un des commutateurs de chaque couple de commutateurs $25_1$ -$26_1$, $25_2$ -$26_2$, $25_3$ -$26_3$ est respectivement connecté, les commutateurs $25_1$, $25_2$, $25_3$, 25m, $26_1$, $26_2$, $26_3$ étant configurés pour connecter le fil $14_1$, $14_2$, $14_3$ au circuit de mesure 16.

L'étage de bouclage 28 comprend pour chaque fil $14_1$, $14_2$, $14_3$ une branche $40_1$, $40_2$, $40_3$, chaque branche $40_1$, $40_2$, $40_3$ comprenant chacune une diode $30_1$, $30_2$, $30_3$ connectée en série d'une résistance $32_1$, $32_2$, $32_3$. Les trois résistances $32_1$, $32_2$, $32_3$ ont la même valeur R.

En outre, le fil 41 connecte l'étage de mesure 20 à la première branche $40_1$ de l'étage de bouclage 28 via l'étage de commutation 25.

Dans la suite, on note que l'anode et la cathode d'une diode $30_1$, $30_2$, $30_3$ sont définies par rapport au sens passant de la diode $30_1$, $30_2$, $30_3$.

Plus précisément, l'anode de chaque diode $30_1$, $30_2$, $30_3$ est connectée respectivement à la résistance $32_1$, $32_2$, $32_3$ de la même branche $40_1$, $40_2$, $40_3$, et la cathode de chaque diode $30_1$, $30_2$, $30_3$ est connectée à la deuxième borne de chaque fil $14_1$, $14_2$, $14_3$.

En outre, l'anode de la diode $30_2$ de la deuxième branche $40_2$ est connectée à la cathode de la diode $30_1$ de la première branche $40_1$ à travers la résistance $32_2$ de la deuxième branche $40_2$, et l'anode de la diode $30_3$ de la troisième branche $40_3$ est connectée à la cathode de la diode $30_2$ de la deuxième branche $40_2$ à travers la résistance $32_3$ de la troisième branche $40_3$.

Autrement dit, la résistance $32_2$ de la deuxième branche $40_2$ est connectée entre le premier fil 14, et la diode $30_2$ de la deuxième branche $40_2$ et la résistance $32_3$ de la troisième branche $40_3$ est connectée entre le deuxième fil $14_2$ et la diode $30_3$ de la troisième branche $40_3$.

Ainsi, l'anode de la diode $30_1$ de la première branche $40_1$ est connectée à la masse m à travers la résistance $32_1$ via le fil 41. La cathode de la diode $30_1$ est reliée à l'anode de la diode $30_2$ de la deuxième branche $40_2$ à travers la résistance $32_2$. La cathode de la diode $30_2$ est reliée à l'anode de la diode $30_3$ de la troisième branche $40_3$ à travers la résistance $32_3$.

Selon le mode de réalisation représenté sur la figure 2, le dispositif de contrôle 10 est propre à contrôler la continuité du câble 12.

La masse m, propre à être connectée à l'étage de mesure 20 via le commutateur $25_m$ ou $26_m$, et la masse m de l'étage de bouclage 28 sont toutes reliées entre elles et peuvent être commutées à l'un des pôles du générateur de tension 22 via les commutateurs $25_m$ ou $26_m$.

Dans le présent exemple, pendant la phase de mesure de continuité, le commutateur $26_m$ est fermé et le commutateur $25_m$ est ouvert. Le fil 41 est donc relié à la polarité positive de l'étage de mesure 20, de sorte à former un circuit fermé en cas de continuité du fil testé.

Le générateur de tension 22 est isolé galvaniquement des tensions éventuellement présentes sur l'installation électrique du bâtiment naval à contrôler, afin d'assurer la protection des personnes contre les risques électriques et pour éviter les perturbations des mesures. Par exemple, l'utilisation d'une batterie comme source d'alimentation du générateur de tension 22 permet de répondre à cette exigence.

En outre, du fait de la polarité du circuit de mesure 16 déterminée par le générateur de tension 22 telle que représentée sur le figure 2, l'étage de bouclage 28 est configuré dans le mode de fonctionnement résistif.

Dans ce mode de fonctionnement, les diodes $30_1$, $30_2$, $30_3$ sont passantes. Autrement dit, le courant $i$ dans le sens dans lequel il est représenté sur la figure 2 est propre à circuler dans le fil 41 et dans chaque branche $40_1$, $40_2$, $40_3$.

Le séquenceur 27 est propre à connecter/déconnecter automatiquement (i.e. sans intervention manuelle d'un opérateur), un par un, un des fils $14_1$, $14_2$, $14_3$.

Chaque fil $14_1$, $14_2$, $14_3$ est identifié par son numéro d'indice $n$, dans l'exemple de la figure 2, $n=\{1,2,3\}$, dans d'autres exemples de réalisation $n=\{1,...,k\}$ où $k=63$.

Lorsque le fil 14, (ou fil d'indice numéro un) est connecté au circuit de mesure 16, le fil 14, est connecté en série de la première branche $40_1$ et les autres fils $14_2$ et $14_3$ ne sont pas connectés au circuit de mesure 16. Une seule résistance $32_1$ du circuit de bouclage 28 est connectée au circuit de mesure 16.

Lorsque le fil $14_2$ (ou fil d'indice numéro deux) est connecté au circuit de mesure 16, le fil $14_2$ est connecté en série de la première branche $40_1$ et de la deuxième branche $40_2$ et les autres fils $14_1$, $14_3$ ne sont pas connectés au circuit de mesure 16. Le courant Í est propre à traverser la première branche $40_1$ et la deuxième branche $40_2$, connectant les résistances $32_1$ et $32_2$ au circuit de mesure 16.

Enfin, lorsque le fil $14_3$ (ou fil d'indice numéro trois) est connecté au circuit de mesure 16, le fil $14_3$ est connecté en série avec la première, la deuxième et la troisième branches $40_1$, $40_2$, $40_3$ et les autres fils $14_1$, $14_2$ ne sont pas connectés au circuit de mesure 16. Le courant $i$ est propre à traverser les trois branches $40_1$, $40_2$, $40_3$ de l'étage de bouclage 28, connectant les résistances $32_1$, $32_2$ et $32_3$ de l'étage de bouclage 28 au circuit de mesure 16.

En fonction du fil identifié $14_1$, $14_2$, $14_3$ connecté au circuit de mesure 16 ou autrement dit, en fonction de l'indice $n$ du fil $14_1$, $14_2$, $14_3$ connecté au circuit de mesure 16, un nombre prédéterminé de résistances $32_1$, $32_2$ et $32_3$ est connecté au circuit de mesure 16.

Dans l'exemple de réalisation de la figure 2, le nombre de résistances $32_1$, $32_2$, $32_3$ connectées au circuit de mesure 16 correspond au numéro d'indice $n$ du fil $14_n$ connecté au circuit de mesure 16.

Ainsi, selon cet exemple, plus le numéro d'indice $n$ du fil $14_n$ est grand, plus le fil $14_n$ est connecté au circuit de mesure 16 avec un nombre élevé de résistances.

En d'autres termes, dans le circuit de mesure 16 selon l'invention, selon le mode de fonctionnement résistif associé au contrôle de continuité du câble 12, un gradient de résistance est généré au sein de l'étage de bouclage 28 en fonction de l'indice $n$ de fil 14 du câble 12. En effet, au fur et à mesure de la connexion fil à fil des fils $14_1$, $14_2$, $14_3$, de plus en plus de résistance $32_1$, $32_2$, $32_3$ sont connectées au circuit de mesure 16.

La tension *Umes* de mesure aux bornes de la résistance 24 de mesure 24 est égale à :

$$Umes = \frac{Rmes * U}{Rmes + n * R} \quad (1)$$

où *Rmes* est la valeur de la résistance de mesure 24, *U* la tension générée par le générateur de tension 22, *n* l'indice du fil $14_1$, $14_2$, $14_3$ connecté au circuit de mesure 16 ou, autrement dit, le nombre de résistances $32_1$, $32_2$, $32_3$, de même valeur, de l'étage de bouclage 28 connectées au circuit de mesure 16, et *R* la valeur commune des résistances $32_1$, $32_2$, $32_3$ connectés au circuit de mesure 16.

La valeur R de chaque résistance $32_1$, $32_2$, $32_3$ est, par exemple de 180 Ω.

La tension aux bornes de la résistance de mesure 24 est propre à être mesurée, et représentative de la qualité de continuité de chaque fil électrique $14_1$, $14_2$, $14_3$ du câble 12. Autrement dit, on entend par « qualité », la continuité satisfaisante d'un fil $14_1$, $14_2$, $14_3$ ou un défaut de continuité d'un fil $14_1$, $14_2$, $14_3$ du câble 12.

Si les fils $14_1$, $14_2$, $14_3$ ne présentent aucun défaut de continuité, la mesure de la tension *Umes* mesurée aux bornes de la résistance de mesure 24, pour chaque fil $14_1$, $14_2$, $14_3$ connecté au circuit de mesure 16, est conforme à la formule (1).

Selon un mode de réalisation, le dispositif de contrôle 10 est propre à contrôler l'isolement du câble 12.

Tous les commutateurs $25_1$, $25_2$, $25_3$, $25_m$, $26_1$, $26_2$, $26_3$, $26_m$ sont par défaut ouverts, c'est-à-dire qu'ils sont dans la position $p_1$. Dans la position ouverte $p_1$, les commutateurs isolent les fils à contrôler $14_1$, $14_2$, $14_3$ de l'étage de mesure 20.

Lors d'un contrôle d'isolement du câble 12 par le dispositif de contrôle 10, la polarité du générateur de tension 22 est propre à être inversée via l'étage de commutation 25 par rapport à sa polarité mise en oeuvre lors d'un contrôle de continuité. L'inversion de la polarité du générateur de tension 22 entraîne un fonctionnement en mode isolant de l'étage de bouclage 28. Autrement dit, le circuit de bouclage 28 isole les fils $14_1$, $14_2$, $14_3$ entre eux.

Plus précisément, la polarité de l'étage de bouclage 28 dans le mode de fonctionnement isolant est donc aussi inversée par rapport à sa polarité dans le mode de fonctionnement résistif. Le sens du courant Í est alors inversé par rapport au sens de circulation du courant Í représenté sur la figure 2. Les diodes $30_1$, $30_2$, $30_3$ sont bloquées et le courant Í ne peut circuler dans l'étage de bouclage 28. L'étage de bouclage 28 n'a donc aucun effet fonctionnel dans ce mode de fonctionnement.

Le séquenceur 27 génère des ordres de commutation en fonction des fils $14_1$, $14_2$, $14_3$ et 41 à contrôler entre eux.

Pour mesurer l'isolement entre le fil 14, et le fil $14_2$, le séquenceur 27 ferme les commutateurs $25_1$ et $26_2$ qui connectent alors le fil 14, à la polarité négative de l'étage de mesure 20 et le fil $14_2$ à la polarité positive de l'étage de mesure 20. S'il y a un défaut d'isolement entre les deux fils $14_1$, $14_2$, un courant de défaut va circuler entre ces deux fils et une tension va apparaître sur la résistance la plus faible du pont diviseur de l'étage de mesure 20. Cette tension sera proportionnelle au courant de défaut, de 0 V si l'isolement est infini à 5 V si l'isolement est nul. A l'issue de la mesure, les commutateurs $25_1$ et $26_2$ sont ouverts par le séquenceur 27.

Pour mesurer l'isolement entre le fil 14, et le fil $14_3$, le séquenceur 27 ferme les commutateurs $25_1$ et $26_3$, qui connectent alors le fil 14, à la polarité négative de l'étage de mesure 20 et le fil $14_3$ à la polarité positive de l'étage de mesure 20. S'il y a un défaut d'isolement entre les deux fils $14_1$, $14_3$, un courant de défaut va circuler entre ces deux fils et une tension va apparaître sur la résistance la plus faible du pont diviseur de l'étage de mesure 20. Cette tension sera proportionnelle au courant de défaut : de 0 V si isolement infini, à 5 V si isolement nul. A l'issue de la mesure, les commutateurs $25_1$ et $26_3$ sont ouverts par le séquenceur 27.

Pour mesurer l'isolement entre le fil $14_2$ et le fil $14_3$, le séquenceur 27 ferme les commutateurs $25_2$ et $26_3$ qui connectent alors le fil $14_2$ à la polarité négative de l'étage de mesure 20 et le fil $14_3$ à la polarité positive de l'étage de mesure 20. S'il y a un défaut d'isolement entre les deux fils $14_2$, $14_3$, un courant de défaut va circuler entre ces deux fils et une tension va apparaître sur la résistance la plus faible du pont diviseur de l'étage de mesure 20. Cette tension sera proportionnelle au courant de défaut, de 0 V si l'isolement est infini, à 5 V si l'isolement nul. A l'issue de la mesure, les commutateurs $25_2$ et $26_3$ sont ouverts par le séquenceur 27.

Pour mesurer l'isolement entre le fil 14, et l'armure du câble 12 symbolisée par le fil 41, le séquenceur 27 ferme les commutateurs $26_1$ et $25_m$ qui connectent le fil 14, à la polarité positive de l'étage de mesure 20 et le fil 41 à la polarité de l'étage de mesure 20. Il n'y a pas circulation de courant à travers la résistance $32_1$ et la diode $30_1$ de l'étage de bouclage 28 en raison de la tension inverse sur la diode $30_1$. S'il y a un défaut d'isolement entre le fil 14, et l'armure du câble 12 symbolisée par le fil 41, un courant de défaut va circuler entre ces deux fils et une tension va apparaître sur la résistance la plus faible du pont diviseur de l'étage de mesure 20. Cette tension sera proportionnelle au courant de défaut, de 0 V si l'isolement est infini, à 5 V si l'isolement est nul. A l'issue de la mesure, les commutateurs $26_1$ et $25_m$ sont ouverts par le séquenceur

Le séquenceur 27 permet de générer toutes les permutations possibles (mesure entre le fil d'indice numéro un et le fil d'indice numéro deux, le fil d'indice numéro un et le fil d'indice numéro trois, le fil d'indice numéro un et le fil d'indice numéro $n$, le fil d'indice numéro deux et le fil d'indice numéro trois, le fil d'indice numéro deux et le fil d'indice numéro $n$. Le séquenceur 27 génère également les séquences de commutation pour les mesures d'isolement entre le fil d'indice numéro un et le fil 41 (symbolisant l'armure du câble 12), le fil d'indice numéro deux et le fil 41, ...le fil d'indice $n$ et le fil 41. Les commutateurs $25_m$ et $26_m$ connectant l'armure du câble symbolisée par le fil 41 sont pilotés par la $64^{ème}$ voie du séquenceur 27 lorsque $k$=63.

L'activation du dispositif de contrôle 10 pour réaliser un contrôle d'isolement et/ou de continuité automatique est réalisée via l'interface utilisateur 18.

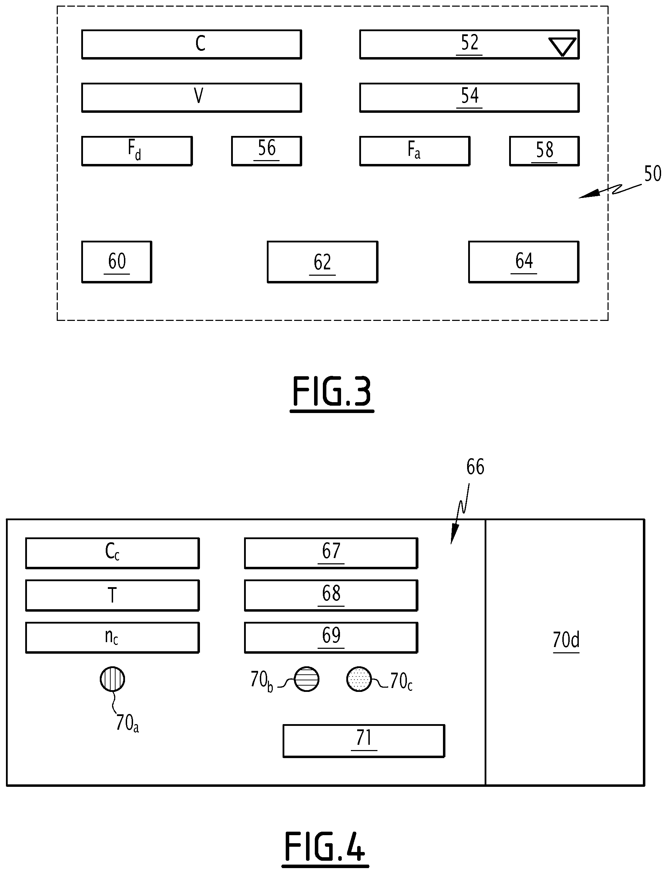

La figure 3 présente une interface d'interaction homme-machine (IHM) 50 propre à être affichée sur l'écran 36 de l'interface utilisateur 18 pour le paramétrage du contrôle du câble 12 à réaliser.

L'interface IHM 50 comprend un premier champ « C » 52 dans lequel une donnée d'identification du câble 12 à contrôler est propre à être saisie et/ou référencée au sein d'une liste de référence de câbles. La valeur de la donnée d'identification du câble 12 à contrôler est par exemple, une fonction du câble 12, un numéro d'identification du câble 12 apparaissant sur les schémas électriques de l'installation.

L'interface IHM 50 présente un deuxième champ « V » 54 dans lequel la valeur de la tension U d'isolement générée par le générateur de tension 22 est propre à être saisie et/ou à être sélectionnée parmi un choix de niveau de tension U. Par exemple, lors de l'activation du champ 54 par le doigt d'un opérateur, un menu déroulant est propre à être affiché, listant trois choix de tensions U parmi 50 V, 250 V et 500 V.

L'interface IHM 50 présente en outre des champs « $F_d$ » 56 et « $F_a$ » 58 dans lesquels une donnée d'identification, par exemple son indice $n$, d'un fil électrique de départ $14_1$ et une donnée d'identification, par exemple son indice $n$, d'un fil électrique d'arrivée $14_3$ sont destinées à être saisie. Autrement dit, l'identification du fil de départ et le choix du fil d'arrivé détermine la liste et l'ordre des fils 14 du câble 12 propre à être contrôlés un à un par le dispositif de contrôle 10.

Cette liste des fils du câble 12 à contrôler est destinée à être transmise au séquenceur 27 pour le pilotage automatique des commutateurs $25_1$, $25_2$, $25_3$, $25_m$

et $26_1$, $26_2$, $26_3$, $26_m$ de l'étage de commutation 25.

L'interface IHM 50 présente en outre des boutons de sélection d'un type de mesure à réaliser par le dispositif de contrôle 10 parmi trois types de mesure.

L'interface IHM 50 comprend, par exemple, un premier bouton 60 tactile de commande du premier type de mesure. Lors de la sélection du premier type de mesure, le dispositif de contrôle 10 réalise automatiquement et successivement un contrôle de la continuité du câble 12 puis un contrôle de l'isolement du câble 12.

En variante, lors de la sélection du premier type de mesure, un contrôle d'isolement est réalisé avant le contrôle de continuité.

L'interface IHM 50 comprend, par exemple, un deuxième bouton 62 tactile de commande d'un deuxième type de mesure. Lors de la sélection du deuxième bouton 62, le dispositif de contrôle 10 est propre à contrôler uniquement l'isolement du câble 12.

Enfin, l'interface IHM 50 comprend, par exemple, un troisième bouton 64 tactile de commande. Lors de la sélection du troisième bouton 64, le dispositif de contrôle 10 est propre à contrôler uniquement la continuité du câble 12.

La figure 4 présente une interface IHM 66 propre à être affichée sur l'écran 36 au cours d'un contrôle d'isolement ou de continuité.

L'interface IHM 66 comprend un premier champ « $C_c$ » 67 identifiant le câble 12 en cours de contrôle par le dispositif de contrôle 10, un deuxième champ « T » 68 indiquant le contrôle en cours parmi un contrôle d'isolement et un contrôle de continuité, et un troisième champ « $n_c$ » 69 indiquant le ou les numéro(s) d'indice(s) $n$ des fils 14 en cours de contrôle.

Dans le cas où un contrôle de la continuité du câble 12 est en cours, l'indice $n$ du fil en cours de connexion au circuit de mesure 16 est indiqué. Par exemple, si la liste des câbles 12 à contrôler comporte les trois fils $14_1$, $14_2$, $14_3$, les numéros d'indices 1, 2 et 3 seront successivement affichés dans le champ 69 en même temps que la connexion du fil $14_1$, $14_2$, $14_3$ correspondant au circuit de mesure 16 par l'étage de commutation 25 est mise en oeuvre.

Dans le cas où un contrôle d'isolement du câble 12 est en cours, les identifiants des couples de fils $14_1$, $14_2$, $14_3$ ou 41 connectés au circuit de mesure 16 sont indiqués. Ces identifiants comprennent par exemple le numéro d'indice $n$ du ou des fil(s) électrique(s) $14_1$, $14_2$, $14_3$ du câble 12 connecté(s) au circuit de mesure 16 et la lettre « m » pour identifier la connexion de l'armure du câble 12, symbolisée par le fil 41, au circuit de mesure 16.

A chaque nouvelle connexion d'un fil $14_1$, $14_2$, $14_3$, 41, les identifiants des couples de fil $14_1$, $14_2$, $14_3$, 41 connectés au circuit de mesure 16 sont actualisés dans le champ 69.

L'interface IHM 66 présente, par exemple, des pastilles colorées verte 70a, orange 70b et rouge 70c propres à être affichées au cours du contrôle d'isolement ou de continuité et représentatives de la qualité du contrôle en cours.

Dans certains exemples de réalisation, l'interface IHM 66 comprend un champ 70d dans lequel les défauts d'isolement et/ou de continuité détectés respectivement lors d'un contrôle d'isolement et/ou de continuité sont propres à être affichés.

Dans le cas d'un contrôle d'isolement, le champ 70d est propre à identifier, par exemple par leur indice $n$, les fils $14_1$, $14_2$, $14_3$, 41 du câble 12 pour lesquels un défaut d'isolement est détecté.

Dans le cas d'un contrôle de continuité, le champ 70d est propre à identifier, par exemple par leur numéro d'indice $n$ le fil du câble 12 pour lequel un défaut de continuité est détecté.

L'interface IHM 66 comprend un bouton 71 tactile de commande propre à arrêter le contrôle en cours lorsqu'il est activé.

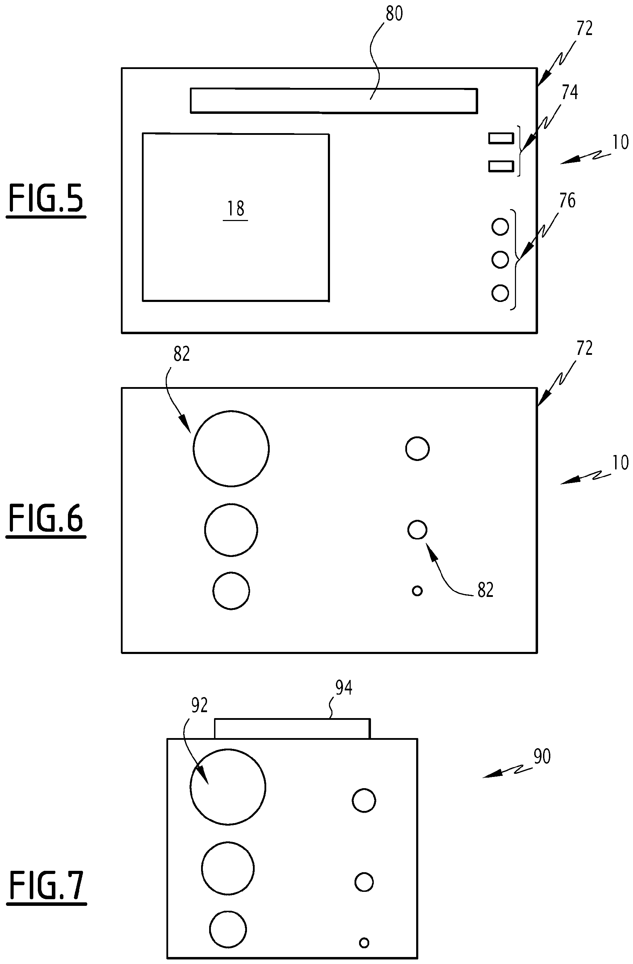

Les figures 5 et 6 montrent respectivement une vue de la face avant et de la face arrière d'un premier boîtier 72 du dispositif de contrôle 10.

Le premier boîtier 72 comprend l'étage de mesure 20, l'étage de commutation 25, le séquenceur 27, et l'interface utilisateur 18.

Le premier boîtier 72 intègre également une batterie autonome (non représentée sur les dessins), par exemple une batterie Lithium-ions (Li-ions). Avantageusement, la batterie autonome, configurée pour alimenter le générateur de tension 22, est propre à de générer la tension U de l'étage de mesure. La batterie permet d'isoler galvaniquement le générateur de tension de l'installation à mesure. La batterie autonome est propre à être raccordée au moyen d'un câble amovible via un connecteur 74 à un dispositif externe de charge. Ce dispositif de charge est également isolé galvaniquement de l'installation à mesurer, afin de pouvoir effectuer des mesures tout en chargeant la batterie amovible.

En référence à la figure 5, l'interface utilisateur 18 est agencée sur la face avant du premier boîtier 72 pour être accessible et visualisable par un opérateur.

La face avant du premier boîtier 72 intègre en outre des connecteurs tels que des connecteurs USB 74 pour la connexion dudit dispositif de contrôle 10 à un ordinateur par exemple et d'autres connecteurs 76.

En particulier et en variante, le dispositif de contrôle 10 comprend un générateur de tension 22 externe connecté au dispositif de contrôle 10 via le connecteur 76. Le dispositif de contrôle 10 comprend alors un étage de génération de tension externe au premier boîtier 72, tel qu'un mégohmmètre, par exemple le mégohmmètre MEGGER MIT 430.

La face avant du premier boîtier 72 comprend en outre au moins une poignée 80 propre à être saisie par un opérateur. Ainsi, le dispositif 10 selon l'invention distribué sur deux boîtiers 70, 72 est aisément transportable.

En référence à la figure 6, la face arrière du premier boîtier 72 intègre différents types d'embases de connexion 82 propre à connecter une première extrémité des différents types de câbles 12 à contrôler, variant notamment par la taille de leur section. En particulier, si les connecteurs des câbles 12 à mesurer sont compatibles, les câbles sont directement connectés aux embases de connexion 82 ou via des jarretières électriques d'adaptation le cas échéant.

Le premier boîtier 72 est réalisé en un matériau résistant et léger, par exemple en aluminium.

Le premier boîtier 72 présente, par exemple, une longueur de 400 millimètres (mm), une largeur de 300 mm, une hauteur de 330 mm et présente un poids inférieur à dix kilogrammes (Kg).

En référence à la figure 7, un deuxième boîtier 90 du dispositif de contrôle 10 est représenté. Le deuxième boîtier 90 intègre l'étage de bouclage 28.

Le deuxième boîtier 90 comprend également différents types d'embases 92 de connexion adaptés pour connecter l'autre extrémité des différents types de câbles 12 à contrôler. Le deuxième boîtier comporte également une poignée 94.

Le deuxième boîtier 90 est également réalisé en un matériau résistant et léger, par exemple en aluminium et pèse également moins de dix kg.

La masse électrique m propre à être connectée à l'étage de mesure 20 via l'un ou l'autre des commutateurs $25_m$ ou $26_m$ et la masse électrique m de l'étage de bouclage 28 correspondent respectivement aux masses électriques des deux boîtiers 72 et 90. Les masses électriques des deux boîtiers 72 et 90 ainsi que tous les composants métalliques (capots des connecteurs, pièces de fixation, etc..) sont propres à être toutes reliées entre elles.

Le dispositif de contrôle 10 est donc compact, autonome en énergie et facilement transportable. Le dispositif 10 est particulièrement adapté au contrôle de câbles 12 dans des environnements exigus, tels que des coursives de navires.

Un procédé de contrôle de l'isolement et/ou de la continuité électrique du câble 12 est décrit dans la suite de la description.

Par l'intermédiaire de menus de paramétrage propres à s'afficher sur l'interface utilisateur 18, l'utilisateur saisi sur l'interface utilisateur 18 les paramètres de la séquence de mesure : la nature du contrôle (isolement ou continuité), la tension U d'essai pour le contrôle d'isolement, le nombre de fils 14 du câble 12. Ces informations sont mémorisées et traitées par le séquenceur 27 qui adresse les commutations, effectue les mesures et mémorise les sanctions.

Plus précisément, dans une première étape du procédé, le dispositif de contrôle 10 reçoit une donnée d'entrée saisie par un opérateur via l'interface utilisateur 18 du dispositif de contrôle 10.

En particulier, l'opérateur renseigne au moins sur l'interface IHM 50 le champ 52 pour identifier le câble 12 à contrôler et le champ 56 identifiant le fil 14, comme fil de départ et le champ 58 identifiant le fil $14_3$ comme fil d'arrivée. La sélection du fil de départ $14_1$ et la sélection

du fil d'arrivée $14_2$ établie une liste ordonnée de fils à tester. En l'espèce, la liste des fils à tester comprend trois fils 14.

Dans le cas où un contrôle d'isolement du câble 12 est à réaliser la tension U d'isolement est choisie. Lorsque l'opérateur appuie sur le champ 54, un menu déroulant comprenant trois choix de tension U de 50V, 250V ou 500V s'ouvre. La tension U d'isolement choisie par l'opérateur est fonction du câble 12 à tester.

Lorsque l'opérateur ne souhaite que réaliser un contrôle de la continuité, le champ 54 n'a pas à être renseigné car une tension U prédéfinie pour le contrôle de continuité est automatiquement générée.

L'opérateur choisit ensuite un type de contrôle à réaliser parmi les trois types de contrôle possibles, soit un contrôle d'isolement et un contrôle de continuité réalisés automatiquement successivement l'un après l'autre ou inversement en sélectionnant le bouton 60, un contrôle d'isolement en sélectionnant le bouton 62 ou un contrôle de la continuité en sélectionnant le bouton 64.

Ainsi, en fonction de la valeur des données d'entrée, à savoir le numéro d'indice $n$ du fil de départ, le numéro d'indice $n$ du fil d'arrivée, et la sélection du type de mesure, une mesure de continuité et/ou d'isolement est automatiquement activée.

Plus précisément, dans le cas où l'opérateur sélectionne une mesure de continuité, l'étage de bouclage 28 est automatiquement dans le mode de fonctionnement résistif.

Durant toute la mesure de continuité, l'étage de commutation 25 pilote le commutateur $26_m$ dans la position fermée $p_2$ afin de connecter le fil 41 au circuit de mesure 16 et plus précisément à la polarité positive du générateur de tension 22.

Puis, l'étage de commutation 25 pilote successivement et automatiquement la fermeture et l'ouverture des commutateurs $25_1$, $25_2$, $25_3$ pour connecter et déconnecter fil à fil successivement chaque fil 14 de la liste des fils à contrôler au circuit de mesure 16.

Plus précisément, le premier commutateur $25_1$ est piloté dans la position fermée $p_2$ pour connecter le premier fil 14, au circuit de mesure 16 et les autres commutateurs $25_2$ et $25_3$, $26_1$, $26_2$, $26_3$ et $25_m$ sont pilotés dans la position ouverte $p_1$. Une seule résistance 32, est connectée au circuit de mesure 16.

Puis, le deuxième commutateur $25_2$ est piloté dans la position fermée $p_2$ pour connecter le deuxième fil $14_2$ au circuit de mesure 16 et les autres commutateurs $25_1$, $25_3$, $26_1$, $26_2$, $26_3$ et $25_m$ sont pilotés dans la position ouverte $p_1$. Les deux résistances $32_1$ et $32_2$ sont connectées au circuit de mesure 16.

Enfin, le troisième commutateur $25_3$ est piloté dans la position ouverte $p_1$ pour connecter le troisième fil $14_3$ au circuit de mesure 16 et les autres commutateurs $25_1$, $25_2$, $26_1$, $26_2$, $26_3$ et $25_m$ sont pilotés dans la position ouverte $p_1$. Les trois résistances $32_1$, $32_2$ et $32_3$ sont connectées au circuit de mesure 16.

Ainsi, à chaque connexion d'un fil $14_1$, $14_2$, $14_3$,

la valeur de la résistance du circuit de mesure 16 est augmentée.

La tension U générée par le générateur de tension 22 est fixée dans ce mode de réalisation à une dizaine de volts. L'étage de mesure 20 détecte une augmentation de tension $U_{rnes}$ proportionnelle au numéro d'indice $n$ du fil commuté, par paliers d'environ 80 millivolt (mV)

A chaque nouvelle connexion d'un fil $14_1$, $14_2$, $14_3$, de la liste de fils du câble 12 à tester la tension $U_{rnes}$ aux bornes de la résistance de mesure 24 est mesurée.

Si la tension $U_{rnes}$ ne correspond pas à la tension $U_{mes}$ calculée avec la formule (1) ci-dessus, un défaut de la continuité du fil $14_1$, $14_2$, $14_3$ est identifié. En particulier, la variation de la tension $U_{rnes}$ mesurée est destinée à être affichée sur l'écran 36. Une variation régulière de la tension $U_{rnes}$ indique une absence de défaut de continuité. Dans le cas contraire, lors d'un défaut de la continuité d'un fil $14_1$, $14_2$, $14_3$, une irrégularité de la variation de la tension $U_{mes}$ est observée. La mémorisation des données de mesure via le microcontrôleur et leur transfert sur un ordinateur permet à posteriori de déterminer l'origine exacte des défauts : détection de défauts de bornage, croisements de fils par exemple caractéristiques des défauts d'isolement, ainsi que des ruptures de continuité des fils 14).

Le nombre $Ncc$ de contrôles de continuité est égal au nombre $LF$ de fils de la liste des fils à contrôler où $LF$ est inférieur ou égal au nombre k de fils 14 du câble 12.

Dans le cas où un opérateur sélectionne un contrôle d'isolement après qu'un contrôle de la continuité du câble 12 a été réalisé, la polarité du générateur de tension 22 est automatiquement inversée selon l'invention dès le passage à la mesure d'isolement, entraînant une inversion de la polarité de l'étage de bouclage 28. L'étage de bouclage est basculé dans le mode de fonctionnement isolant et les diodes $30_1$, $30_2$, $30_3$ sont bloquées.

Pour la mesure d'isolement, le module de commutation 25 connecte automatiquement et successivement le premier fil 14, de la liste des fils à tester avec l'armure du câble 12 symbolisée par le fil 41 sur la figure 2 puis avec les autres fils $14_2$, $14_3$ de la liste un à un.

Plus précisément, le premier commutateur $26_1$ et le commutateur $25_m$ de l'armure du câble symbolisée par le fil 41 sont pilotés en position fermée $p_2$ pour connecter le premier fil 14, du circuit de mesure 16 et le fil 41 du circuit de mesure 16. Dans ce cas, les autres commutateurs $25_1$, $25_2$, $25_3$, $26_2$, $26_3$, $26_m$ sont en position ouverte $p_1$.

Puis, le premier commutateur $25_1$ et le deuxième commutateur $26_2$ sont pilotés en position fermée $p_2$ pour connecter le premier fil 14, et le deuxième fil $14_2$ au circuit de mesure 16. Dans ce cas les autres commutateurs $25_2$, $25_3$, $25_m$, $26_1$, $26_3$, et $26_m$ sont pilotés en position ouverte $p_1$.

Enfin, le premier commutateur $25_1$ et le troisième commutateur $26_3$ sont pilotés en position fermée $p_2$

pour connecter le premier fil 14, et le troisième et dernier fil $14_3$ de la liste au circuit de mesure 16. Dans ce cas, les autres commutateurs $25_2$, $25_3$, $25_m$, $26_1$, $26_2$ et $26_m$ sont pilotés en position ouverte $p_1$.

Une fois que l'isolement du premier fil 14, avec les autres fils du câble 12 y compris le fil 41 symbolisant l'armure du câble 12 est contrôlé, le séquenceur 27 contrôle le commutateur $25_2$ en position fermée $p_2$ pour connecter le fil suivant $14_2$ au circuit de mesure 16 et contrôle le commutateur $26_3$ en position fermée $p_2$ pour contrôler l'isolement du fil $14_2$ avec le fil $14_3$. Puis les commutateurs $26_2$ et $25_m$ sont pilotés en position fermée $p_2$ pour contrôler l'isolement entre le fil $14_2$ et l'armure du câble 12 symbolisée par le fil 41.

Enfin, le séquenceur 27 contrôle les commutateurs $26_3$ et $25_m$ en position fermée $p_2$ pour contrôler l'isolement entre le fil $14_3$ et l'armure du câble 12.

Le nombre *Nci* de contrôles à réaliser est égal à

$$Nci = \frac{LF*(LF+1)}{2}$$

Où *LF* est le nombre de fils 14 de la liste des fils du câble 12 à contrôler. Le nombre *LF* de fils 14 de la liste des fils à contrôler du câble 12 est inférieur ou égal au nombre k de fils 14 du câble 12.

Le nombre Nci de contrôles d'isolement à réaliser correspond au nombre de connexions simultanées de deux fils $14_1$, $14_2$, $14_3$ du câble 12 et d'un fil du câble $14_1$, $14_2$, $14_3$ avec l'armure du câble 12.

A chaque nouvelle connexion d'un fil $14_1$, $14_2$, $14_3$, de la liste de fils du câble 12 à contrôler la tension *Urnes* aux bornes de la résistance de mesure 24 est mesurée pour détecter un défaut d'isolement des fils entre eux ou avec le fil 41 connecté à la masse m.

Lorsque l'opérateur sélectionne le contrôle successif et automatique de la continuité et de l'isolement ou inversement, une fois que le dispositif 10 a terminé le contrôle de la continuité, la polarité de l'étage de bouclage 28 est inversée automatiquement par inversion automatique de la polarité du générateur de tension 22.

Ainsi, selon l'invention, le contrôle de la continuité et/ou de l'isolement est réalisé de manière particulièrement fiable. En effet, la connexion successive des différents fils du câble de la liste des câbles à tester est réalisée de manière automatique et les erreurs de connexion des fils sont évitées.

En outre, la programmation initiale de la tension U pour le contrôle d'isolement et de continuité assure également la fiabilité des mesures, la lecture de la tension associée au câble 12 à contrôler étant automatiquement sélectionnée.

Ainsi, le contrôle des câbles est donc réalisé de manière simple et rapide. Ceci est particulièrement avantageux dans le domaine naval où un très grand nombre de câbles sont à contrôler.

## Revendications

1. Dispositif de contrôle (10) d'isolement et de continuité d'au moins un câble électrique (12) comportant une pluralité de fils électriques ($14_1$, $14_2$, $14_3$), le dispositif (10) comprenant un circuit de mesure (16) connectable aux fils électriques ($14_1$, $14_2$, $14_3$) du câble (12), le circuit de mesure (16) comprenant :

   - un étage de mesure (20) comprenant au moins un générateur de tension (22) ;
   - un étage de commutation (25), connectable à l'étage de mesure (20), propre à connecter automatiquement et successivement chaque fil électrique ($14_1$, $14_2$, $14_3$) au circuit de mesure (16) et propre à connecter le circuit de mesure (16) à la masse (m) ;
   - un étage de bouclage (28) du circuit de mesure (16) connectable, fil électrique à fil électrique du câble (12), à l'étage de commutation (25) ;

   **caractérisé en ce que** l'étage de bouclage (28) est configuré pour fonctionner automatiquement selon deux modes de fonctionnement, isolant et résistif, associés respectivement au contrôle d'isolement et au contrôle de continuité de câble électrique (12).

2. Dispositif de contrôle selon la revendication 1, dans lequel la polarité de l'étage de bouclage (28) dans le mode de fonctionnement isolant et la polarité de l'étage de bouclage (28) dans le mode de fonctionnement résistif sont inversées.

3. Dispositif de contrôle selon l'une quelconque des revendications précédentes, dans lequel l'étage de bouclage (28) comprend pour chaque fil ($14_1$, $14_2$, $14_3$) au moins un composant ($30_1$, $30_2$, $30_3$) à passage unidirectionnel du courant électrique, chaque composant ($30_1$, $30_2$, $30_3$) à passage unidirectionnel du courant électrique étant passant lorsque l'étage de bouclage (28) est dans le mode de fonctionnement résistif, et bloqué lorsque l'étage de bouclage (28) est dans le mode de fonctionnement isolant.

4. Dispositif de contrôle selon la revendication 3, dans lequel l'étage de bouclage (28) comprend pour chaque fil ($14_1$, $14_2$, $14_3$) au moins une résistance ($32_1$, $32_2$, $32_3$) avec ledit au moins un composant unidirectionnel.

5. Dispositif de contrôle selon l'une quelconque des revendications précédentes, dans lequel l'étage de commutation (25) comprend des commutateurs électroniques ($25_1$, $25_2$, $25_3$), notamment des commutateurs CMOS.

6. Dispositif de contrôle selon la revendication 5, dans lequel les commutateurs électroniques ($25_1$, $25_2$,

$25_3$) sont automatiquement pilotés par un registre à décalage.

7. Dispositif de contrôle selon l'une quelconque des revendications précédentes, dans lequel l'étage de mesure (20) comprend, en série du générateur de tension (22), une résistance de mesure (24), la tension *(Umes)* aux bornes de la résistance de mesure (24) étant propre à être mesurée, et représentative de la qualité d'isolement et/ou de continuité de chaque fil électrique ($14_1$, $14_2$, $14_3$) du câble (12).

8. Dispositif de contrôle selon l'une quelconque des revendications précédentes, dans lequel le générateur de tension (22) est un générateur de tension variable.

9. Dispositif de contrôle selon l'une quelconque des revendications précédentes, dans lequel le dispositif de contrôle (10) est transportable manuellement et comprend une batterie.

10. Procédé de contrôle d'isolement et de continuité d'au moins un câble électrique comportant une pluralité de fils électriques, le procédé étant mis en oeuvre automatiquement par un dispositif (10) de contrôle selon l'une quelconque des revendications 1 à 9, le dispositif de contrôle comprenant un circuit de mesure (16) connectable aux fils électriques ($14_1$, $14_2$, $14_3$) du câble (12), le circuit de mesure (16) comprenant :

   - un étage de mesure (20) comprenant au moins un générateur de tension (22) ;
   - un étage de commutation (25), connectable à l'étage de mesure (20), propre à connecter automatiquement et successivement chaque fil électrique ($14_1$, $14_2$, $14_3$) au circuit de mesure (20) et propre à connecter le circuit de mesure (16) à la masse ;
   - un étage de bouclage (28) du circuit de mesure (16) connectable fil à fil à l'étage de commutation (25) ;

   le procédé comprenant les étapes suivantes mises en oeuvre automatiquement par le dispositif de contrôle :

   - réception d'une donnée d'entrée saisie via une interface (18) du dispositif de contrôle (10),
   - en fonction de la valeur de ladite donnée d'entrée, activation automatique et successive de deux modes de fonctionnement de l'étage de bouclage (28), isolant puis résistif ou résistif puis isolant, le mode de fonctionnement isolant étant associé au contrôle d'isolement, le mode de fonctionnement résistif étant associé au contrôle de continuité de câble électrique (12),

   - mesure de la tension *(Umes)* aux bornes d'une résistance de mesure (24) de l'étage de mesure (20), après connexion successive de chaque fil électrique ($14_1$, $14_2$, $14_3$) dudit au moins un câble au circuit de mesure (16) par l'étage de commutation (25) du circuit de mesure (16) jusqu'à détection d'un défaut d'isolement et/ou de continuité dudit fil ($14_1$, $14_2$, $14_3$) électrique, ou jusqu'à connexion de l'ensemble des fils électriques ($14_1$, $14_2$, $14_3$) dudit au moins un câble (12).

**Patentansprüche**

1. Prüfungsvorrichtung (10) der Isolierung und des Durchgangs mindestens eines elektrischen Kabels (12), umfassend eine Vielzahl von elektrischen Leitungen ($14_1$, $14_2$, $14_3$), die Vorrichtung (10) umfassend eine Messschaltung (16), die mit den elektrischen Leitungen ($14_1$, $14_2$, $14_3$) des Kabels (12) verbunden werden kann, die Messschaltung (16) umfassend:

   - eine Messstufe (20) umfassend mindestens einen Spannungsgenerator (22);
   - eine Schaltstufe (25), die mit der Messstufe (20) verbunden werden kann, die geeignet ist, jeden elektrischen Draht ($14_1$, $14_2$, $14_3$) automatisch und nacheinander mit der Messschaltung (16) zu verbinden, und die geeignet ist, um die Messschaltung (16) mit Masse (m) zu verbinden;
   - eine Rückschleifstufe (28) der Messschaltung (16), die von elektrischer Leitung zu elektrischer Leitung des Kabels (12) mit der Schaltstufe (25) verbunden werden kann;

   **dadurch gekennzeichnet, dass** die Rückschleifstufe (28) konfiguriert ist, um automatisch in zwei Betriebsmodi, isolierend und resistiv, zu funktionieren, die jeweils mit der Isolationsprüfung und der Durchgangsprüfung des elektrischen Kabels (12) assoziiert sind.

2. Prüfungsvorrichtung nach Anspruch 1, wobei die Polarität der Rückkopplungsstufe (28) in dem isolierenden Betriebsmodus und die Polarität der Rückkopplungsstufe (28) in dem resistiven Betriebsmodus umgekehrt sind.

3. Prüfungsvorrichtung nach einem der vorherigen Ansprüche, wobei die Schleifenstufe (28) für jeden Draht ($14_1$, $14_2$, $14_3$) mindestens eine Komponente ($30_1$, $30_2$, $30_3$) mit unidirektionalem Durchgang für elektrischen Strom umfasst, wobei die Komponente ($30_1$, $30_2$, $30_3$) mit unidirektionalem Durchgang für elektrischen Strom durchlässig ist, wenn die Schleifenstufe (28) in dem resistiven Betriebsmodus ist, und blockiert ist, wenn die Schleifenstufe (28) in dem isolierenden Betriebsmodus ist.

4. Prüfungsvorrichtung nach Anspruch 3, wobei die Schleifenstufe (28) für jeden Draht ($14_1$, $14_2$, $14_3$) mindestens einen Widerstand ($32_1$, $32_2$, $32_3$) mit der mindestens eine unidirektionale Komponente umfasst.

5. Prüfungsvorrichtung nach einem der vorherigen Ansprüche, wobei die Schaltstufe (25) elektronische Schalter ($25_1$, $25_2$, $25_3$), insbesondere CMOS-Schalter, umfasst.

6. Prüfungsvorrichtung nach Anspruch 5, wobei die elektronischen Schalter ($25_1$, $25_2$, $25_3$) automatisch von einem Schieberegister angesteuert werden.

7. Prüfungsvorrichtung nach einem der vorherigen Ansprüche, wobei die Messstufe (20) in Reihe mit dem Spannungsgenerator (22) einen Messwiderstand (24) umfasst, wobei die Spannung *(Umes)* an den Klemmen des Messwiderstands (24) gemessen werden kann und repräsentativ für die Isolations- und/oder Durchgangsqualität von jedem elektrischen Draht ($14_1$, $14_2$, $14_3$) des Kabels (12) ist.

8. Prüfungsvorrichtung nach einem der vorherigen Ansprüche, wobei der Spannungsgenerator (22) ein Generator variabler Spannung ist.

9. Prüfungsvorrichtung nach einem der vorherigen Ansprüche, wobei die Prüfungsvorrichtung (10) manuell transportiert werden kann ist und eine Batterie umfasst.

10. Verfahren zur Isolations- und Durchgangsprüfung von mindestens einem elektrischen Kabel umfassend eine Vielzahl von elektrischen Drähten, wobei das Verfahren automatisch von einer Prüfungsvorrichtung (10) nach einem der Ansprüche 1 bis 9 durchgeführt wird, die Prüfungsvorrichtung umfassend eine Messschaltung (16) umfasst, die mit den elektrischen Drähten ($14_1$, $14_2$, $14_3$) des Kabels (12) verbunden werden kann, die Messschaltung (16) umfassend:

- eine Messstufe (20) umfassend mindestens einen Spannungsgenerator (22);
- eine Schaltstufe (25), die mit der Messstufe (20) verbunden werden kann, die geeignet ist, jeden elektrischen Draht ($14_1$, $14_2$, $14_3$) automatisch und nacheinander mit der Messschaltung (20) zu verbinden, und die geeignet ist, um die Messschaltung (16) mit Masse zu verbinden;
- eine Rückschleifstufe (28) der Messschaltung (16), die Draht für Draht mit der Schaltstufe (25) verbunden werden kann;

wobei das Verfahren die folgenden Schritte umfasst, die automatisch von der Prüfungsvorrichtung durchgeführt werden:

- Empfangen von Eingangsdaten, die über eine Schnittstelle (18) der Prüfungsvorrichtung (10) eingegeben werden,
- abhängig von dem Wert der Eingangsdaten, automatische und aufeinanderfolgende Aktivierung von zwei Betriebsmodi der Schleifenstufe (28), isolierend und dann resistiv oder resistiv und dann isolierend, wobei der isolierende Betriebsmodus mit der Isolationsprüfung assoziiert ist, der resistive Betriebsmodus mit der Prüfung des Durchgangs des elektrischen Kabels (12) assoziiert ist,
- Messen der Spannung *(Umes)* an den Klemmen eines Messwiderstands (24) der Messstufe (20), nach aufeinanderfolgender Verbindung jedes elektrischen Drahts ($14_1$, $14_2$, $14_3$) des mindestens eines Kabels mit dem Messkreis (16) durch die Schaltstufe (25) des Messkreises (16) bis zum Erfassen eines Isolations- und/oder Durchgangsfehlers des elektrischen Drahtes ($14_1$, $14_2$, $14_3$), oder bis zum Verbinden aller elektrischen Drähte ($14_1$, $14_2$, $14_3$) des mindestens eines Kabels (12).

**Claims**

1. Monitoring device (10) for monitoring the insulation and/or continuity of at least one electric cable (12) including a plurality of electrical wires ($14_1$, $14_2$, $14_3$), wherein the device (10) comprises a measuring circuit (16) that can be connected to the electrical wires ($14_1$, $14_2$, $14_3$) of the cable (12), the measuring circuit (16) comprising:

- a measuring stage (20) comprising at least one voltage generator (22);
- a switching stage (25), that can be connected to the measuring stage (20), suited to connect each electrical wire ($14_1$, $14_2$, $14_3$) automatically and successively to the measuring circuit (16) and/or suited to connect the measuring circuit (16) to ground (m);
- a looping stage (28) of the measuring circuit (16) that can be connected, electrical wire to electrical wire of the cable (12), to the switching stage (25);

the looping stage (28) being configured to operate automatically in at least one of two modes, insulating or resistive, respectively associated with the monitoring of the insulation or the monitoring of the continuity of the electrical cable (12).

2. Monitoring device according to claim 1, wherein the polarity of the looping stage (28) in the insulating mode is the reverse of the polarity of the looping stage (28) in the resistive mode.

3. Monitoring device according to any one of the preceding claims, wherein, for each wire ($14_1$, $14_2$, $14_3$), the looping stage (28) comprises at least one component ($30_1$, $30_2$, $30_3$) for the unidirectional passage of electrical current, wherein each component ($30_1$, $30_2$, $30_3$) for the unidirectional passage of electrical current is turned on when the looping stage (28) is in the resistive mode and is blocked when the looping stage (28) is in the insulating mode.

4. Monitoring device according to claim 3, wherein for each wire ($14_1$, $14_2$, $14_3$) the looping stage (28) comprises at least one resistor ($32_1$, $32_2$, $32_3$) with the at least one unidirectional component.

5. Monitoring device according to any one of the preceding claims, wherein the switching stage (25) comprises electronic switches ($25_1$, $25_2$, $25_3$), in particular CMOS switches.

6. Monitoring device according to claim 5, wherein the electronic switches ($25_1$, $25_2$, $25_3$) are automatically controlled by a shift register.

7. Monitoring device according to any one of the preceding claims, wherein the measuring stage (20) comprises, connected in series to the voltage generator (22), a measuring resistor (24), wherein the voltage *(Umes)* at the terminals of the measuring resistor (24) being suited to be measured, and representative of the quality of the insulation and/or the continuity of each electrical wire ($14_1$, $14_2$, $14_3$) of the cable (12).

8. Monitoring device according to any one of the preceding claims, wherein the voltage generator (22) is a variable voltage generator.

9. Monitoring device according to any one of the preceding claims, wherein the monitoring device (10) is manually transportable and comprises a battery.

10. Method for monitoring the insulation and/or continuity of at least one electrical cable including a plurality of electrical wires, the method being automatically carried out by a monitoring device (10) according to any one of claims 1 to 10, wherein the monitoring device comprises a measuring circuit (16) that can be connected to the electrical wires ($14_1$, $14_2$, $14_3$) of the cable (12), the measuring circuit (16) comprising:

- a measuring stage (20) comprising at least one voltage generator (22);
- a switching stage (25), that can be connected to the measuring stage (20), suited to connect each electrical wire ($14_1$, $14_2$, $14_3$) automatically and successively to the measuring circuit (20);
- a looping stage (28) for the measuring circuit (16) that can be connected wire to wire to the switching stage (25);

the method comprising the following steps, carried out automatically by the monitoring device:

- receipt of input data via an interface (18) of the monitoring device (10),
- depending on the value of the input data, automatically activating at least one of two modes of the looping stage (28), insulating or resistive, respectively associated with the monitoring of the insulation or the monitoring of the continuity of the electrical cable (12),
- measuring the voltage *(Umes)* at the terminals of a measuring resistor (24) of the measuring stage (20), after the successive connection of each electrical wire ($14_1$, $14_2$, $14_3$) of the at least one cable to the measuring circuit (16) by the switching stage (25) of the measuring circuit (16) until an insulation and/or continuity failure of the electrical wire ($14_1$, $14_2$, $14_3$) is detected, or until all of the electrical wires ($14_1$, $14_2$, $14_3$) of the said at least one cable (12) are connected.

FIG.1

## FIG.2

| C | | 52 ▽ |
|---|---|---|
| V | | 54 |
| $F_d$ | 56 | $F_a$ | 58 |

| 60 | 62 | 64 |

50

# FIG.3

66

| $C_c$ | 67 | |
|---|---|---|
| T | 68 | 70d |
| $n_c$ | 69 | |

70a

70b 70c

| 71 |

# FIG.4

**FIG.5**

**FIG.6**

**FIG.7**

**RÉFÉRENCES CITÉES DANS LA DESCRIPTION**

**Documents brevets cités dans la description**

- US 3986106 A
- US 4445086 A
- US 5155440 A